# FASCICULE DE BREVET EUROPEEN

(11) **EP 2 147 323 B1**
(45) Date de publication et mention de la délivrance du brevet: **11.01.2017**
(21) Numéro de dépôt: 08805549.6
(22) Date de dépôt: 07.05.2008
(51) Int. Cl.: H02J 7/00, H02J 7/35, H02S 50/10, G01R 31/36

(54) **PROCÉDÉ DE DIAGNOSTIC D'ÉLÉMENTS DÉFECTUEUX DANS UN SYSTÈME AUTONOME, ALIMENTÉ PAR UNE SOURCE D'ALIMENTATION INTERMITTENTE**
VERFAHREN ZUR DIAGNOSTIZIERUNG DEFEKTER ELEMENTE IN EINEM DURCH EINE INTERMITTIERENDE STROMQUELLE ANGETRIEBENEN STANDALONE-SYSTEM
METHOD OF DIAGNOSING DEFECTIVE ELEMENTS IN A STANDALONE SYSTEM, POWERED BY AN INTERMITTENT POWER SOURCE

(30) Priorité: 11.05.2007 FR 0703369
(43) Date de publication de la demande: 27.01.2010
(73) Titulaire: Commissariat à l'Énergie Atomique et aux Énergies Alternatives, 75015 Paris (FR)
(72) Inventeur: LABRUNIE, Antoine, F-75005 Paris (FR); GENIES, Sylvie, F-38120 Saint Egreve (FR)
(74) Mandataire: de Jong, Jean Jacques
(86) Numéro de dépôt international: PCT/FR2008/000644
(87) Numéro de publication internationale: WO 2008/152238

(56) Documents cités:
- JP-A- 2005 340 464
- US-A1- 2002 059 035
- US-A1- 2006 145 658
- IMAMURA M S ET AL COMMISSION OF THE EUROPEAN COMMUNITIES: "REAL-TIME MONITORING/DIAGNOSTIC SYSTEM FOR PHOTOVOLTAIC PLANT AND BATTERY" 11TH. E.C. PHOTOVOLTAIC SOLAR ENERGY CONFERENCE. PROCEEDINGS OF THE INTERNATIONAL CONFERENCE, MONTREUX, OCT. 12 - 16, 1992, PROCEEDINGS OF THE INTERNATIONAL PHOTOVOLTAIC SOLAR ENERGY CONFERENCE, CHUR, HARWOOD ACADEMIC, CH, vol. CONF. 11, 12 octobre 1992 (1992-10-12), pages 1266-1270, XP001137808 ISBN: 3-7186-5380-X
- ORTEGA C ET AL: "Monitoring and charge-control of lead-acid batteries in photovoltaic applications" TELECOMMUNICATIONS ENERGY CONFERENCE, 2004. INTELEC 2004. 26TH ANNUAL INTERNATIONAL CHICAGO, IL, USA SEPT. 19-23, 2004, PISCATAWAY, NJ, USA,IEEE, 19 septembre 2004 (2004-09-19), pages 260-263, XP010774444 ISBN: 0-7803-8458-X
- BENGHANEM M ET AL: "Data acquisition system for photovoltaic systems performance monitoring" INSTRUMENTATION AND MEASUREMENT TECHNOLOGY CONFERENCE, 1997. IMTC/97. PROCEEDINGS. SENSING, PROCESSING, NETWORKING., IEEE OTTAWA, ONT., CANADA 19-21 MAY 1997, NEW YORK, NY, USA,IEEE, US, vol. 2, 19 mai 1997 (1997-05-19), pages 1030-1033, XP010233725 ISBN: 0-7803-3747-6

## Description

### Domaine technique de l'invention

L'invention est relative à un procédé de diagnostic d'éléments défectueux dans un système autonome, alimenté par une source d'alimentation intermittente et comportant en série un générateur, un régulateur de puissance et un élément de stockage d'énergie, le régulateur d'énergie pouvant comporter un convertisseur de puissance.

### État de la technique

Les systèmes autonomes alimentés par des sources d'énergie intermittentes (par exemple : des panneaux photovoltaïques, des générateurs de type éoliens...) sont appelés à se développer. De plus, ces systèmes autonomes seront préférentiellement installés dans des endroits isolés, d'accès difficile pour lesquels le coût d'une alimentation classique en énergie, par câble, serait prohibitif. Dans ce type de configuration, l'optimisation de l'entretien et de l'autonomie revêt un caractère primordial pour permettre une réduction importante des coûts de fonctionnement.

Or, les systèmes classiques, s'ils permettent parfois de suivre la production d'énergie, ne sont pas conçus pour réagir en cas de faible production, ni pour informer l'utilisateur ou le personnel de maintenance de l'origine d'un défaut.

Dans un système autonome conventionnel, la batterie peut être branchée directement sur le panneau photovoltaïque. Le panneau photovoltaïque est conçu (nombre et disposition des cellules) pour charger une batterie au plomb. Le point de puissance du panneau photovoltaïque est ajusté par la tension aux bornes de la batterie. En effet, plus la batterie est chargée, plus sa tension est élevée et plus le courant délivré par le panneau est faible. Enfin, les batteries au plomb supportent facilement les surcharges.

Cependant, dans la plupart des systèmes autonomes :
- il y a une gestion de la charge de la batterie (seuils de tension, connexion / déconnexion des différentes charges),
- il n'y a pas de composant de conversion de puissance,
- il y a une surveillance de la production du système,
- il n'y a pas de surveillance du fonctionnement du panneau.

La demande de brevet japonais JP2005340464 décrit un système de diagnostic utilisant la comparaison du rapport de la puissance instantanée sur la puissance standard entre les différents panneaux d'une centrale photovoltaïque. Le bon fonctionnement ou le mauvais fonctionnement des panneaux photovoltaïques est déduit de cette comparaison. La puissance standard des différents panneaux photovoltaïques en fonction de l'heure ainsi que la puissance délivrée par chaque panneau durant les journées précédentes ont été préalablement mises en mémoire dans le système.

Le brevet US6892165 décrit le calcul de caractéristiques standard d'un système photovoltaïque, calcul basé sur les conditions d'installation du système, et la comparaison de cette valeur standard à des valeurs mesurées. Le bon fonctionnement du système est déduit de cette comparaison.

Le document "Real-time Monitoring / Diagnostic System for Photovoltaic Plant Battery", M.S. Imamura et al., Photovoltaic Solar Energy Converence, Octobre 1992, Suisse, décrit un procédé diagnostic pour des systèmes photovoitaïques.

Dans les systèmes de gestion des installations autonomes actuelles, l'utilisateur (ou le personnel d'entretien) est prévenu trop tard, lorsqu'il n'y a plus de source d'énergie et que la batterie est déchargée. De plus, l'utilisateur n'a aucune information sur la cause de la défaillance.

### Objet de l'invention

L'objet de l'invention consiste à pallier les inconvénients précités et en particulier à détecter les causes de défaillance avant qu'il n'y ait plus de source d'énergie et que la batterie soit déchargée.

Ce but est atteint par un procédé selon les revendications annexées et plus particulièrement dans une première variante de réalisation par le fait que le procédé comporte
- la mesure du courant et de la tension réels de charge, la détermination en fonction desdites mesures de la puissance réelle de charge de l'élément de stockage d'énergie, la comparaison de ladite puissance réelle de charge à un seuil de puissance prédéfini,
- la déconnexion de l'élément de stockage d'énergie si la puissance de charge est inférieure au seuil de puissance,
- l'élément de stockage d'énergie étant déconnecté, la mesure de la puissance maximale délivrable par le générateur à l'instant de la mesure, la détermination de l'état de charge de l'élément de stockage d'énergie déconnecté, ainsi que de la tension et de la puissance théoriques de charge correspondant,
- la différenciation entre un comportement normal, un mauvais fonctionnement du générateur et un mauvais fonctionnement de l'élément de stockage d'énergie en fonction de la comparaison entre la puissance réelle de charge de l'élément de stockage et la plus petite des valeurs représentatives de la puissance théorique de charge de l'élément de stockage d'énergie et de la puissance maximale délivrable par le générateur et de la comparaison entre la tension réelle de charge et la tension théorique de charge de l'élément de stockage d'énergie.

Ce but est également atteint dans une seconde variante de réalisation particulière par le fait que l'élément de stockage d'énergie étant connectés directement par des moyens de commutation, le procédé comporte
- la mesure d'un courant réel de charge (Ibatt) et d'une tension réelle de charge (Ubatt), la comparaison du courant réel de charge (Ibatt) à un premier seuil de courant prédéfini (Iseuil),
- la déconnexion de l'élément de stockage d'énergie (1) si ledit courant réel de charge (Ibatt) est inférieur au seuil de courant (Iseuil),
- l'élément de stockage d'énergie (1) étant déconnecté, la mesure du courant maximal (Imax) et de la tension maximale (Umax) délivrables par le générateur (2) à l'instant de la mesure, la détermination de l'état de charge (SOC) de l'élément de stockage d'énergie (1) déconnecté, d'un courant théorique de charge (Ithbatt) et d'une tension théorique de charge (Uthbatt),
- la différenciation entre un comportement normal, un mauvais fonctionnement du système autonome en fonction de la comparaison du courant réel de charge (Ibatt) avec le courant théorique de charge (Ithbatt).

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente de façon schématique un système autonome dans lequel le procédé selon l'invention peut être mis en oeuvre.
La figure 2 représente, sous forme d'organigramme, un mode particulier de réalisation d'un procédé selon l'invention.
La figure 3 illustre un mode particulier de réalisation du test du régulateur du procédé selon la figure 2.
La figure 4 représente, sous forme d'organigramme, un second mode particulier de réalisation d'un procédé selon l'invention.
La figure 5 représente, de manière schématique, les caractéristiques électriques de l'élément de stockage d'énergie et du générateur, dans un fonctionnement normal selon le mode particulier de réalisation illustré à la figure 4.
Les figures 6 et 7 représentent, de manière schématique, les caractéristiques électriques de l'élément de stockage d'énergie et du générateur, dans un mauvais fonctionnement de l'élément de stockage d'énergie et du générateur selon le mode particulier de réalisation illustré à la figure 4.

### Description d'un mode particulier de réalisation de l'invention

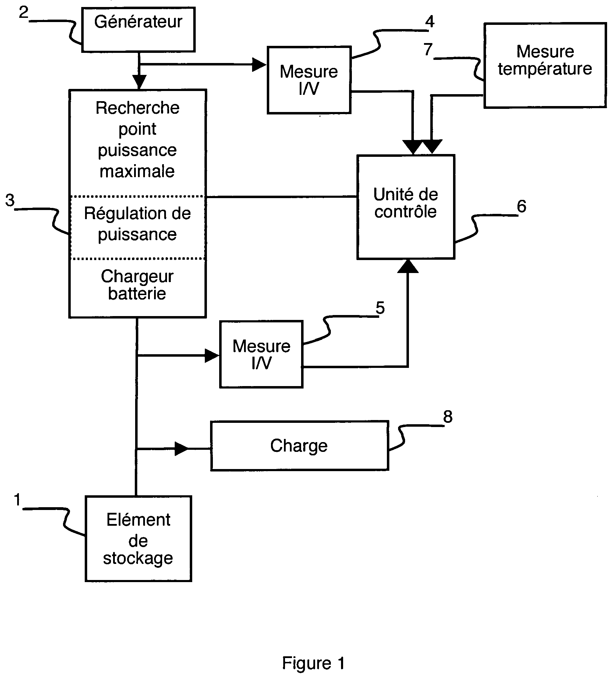

Comme illustré sur la figure 1, le système autonome comporte au moins une batterie 1 constituant un élément de stockage d'énergie, un générateur 2 d'énergie, délivrant une alimentation intermittente, et un régulateur de puissance 3 connecté entre le générateur 2 et la batterie 1. Le régulateur de puissance 3 comporte, avantageusement, non seulement un circuit de régulation de la puissance mais également un module de recherche du point de puissance maximale délivrable par le générateur 2, avec un algorithme de recherche correspondant, et un module de charge de l'élément de stockage d'énergie 1 avec un algorithme de charge dédié. Les algorithmes de recherche et de charge peuvent être intégrés dans le régulateur de puissance 3 et/ou dans une unité de contrôle 6. Des circuits de mesures 4 et 5, permettant respectivement de mesurer la tension et le courant à la sortie du générateur 2 et aux bornes de la batterie 1, sont connectés à une unité de contrôle 6, également connectée au régulateur de puissance 3. Un circuit 7 de mesure de la température est également connecté à l'unité de contrôle 6 et une charge 8 est classiquement alimentée par la batterie 1.

Le générateur 2 d'énergie est, par exemple, de type éolien ou micro-hydraulique ou avantageusement un panneau photovoltaïque.

Le régulateur de puissance 3 comporte, de préférence, un convertisseur de type BUCK. L'unité de contrôle 6 est ainsi destinée à gérer, par l'intermédiaire du régulateur de puissance 3, l'adéquation entre la puissance fournie par le générateur 2 et la charge de la batterie 1.

L'unité de contrôle 6 commande l'ouverture et la fermeture d'éléments de commutation (non représentés) connectés entre le panneau photovoltaïque 2 et la batterie 1 et destinés à permettre la déconnexion de la batterie 1. Les éléments de commutation sont, de préférence, intégrés au régulateur de puissance 3.

De manière avantageuse, des données relatives à des profils de charge de la batterie 1, permettant de déterminer la puissance de charge théorique Pthbatt ainsi que la tension de charge théorique Uthbatt en fonction de l'état de charge et de la température de la batterie 1, sont mises en mémoire dans l'unité de contrôle 6.

Le circuit 7 mesure, avantageusement, la température T de la batterie 1.

Le système autonome comporte, avantageusement, un dispositif de communication avec l'extérieur (non représenté), qui peut être intégré dans l'unité de contrôle 6.

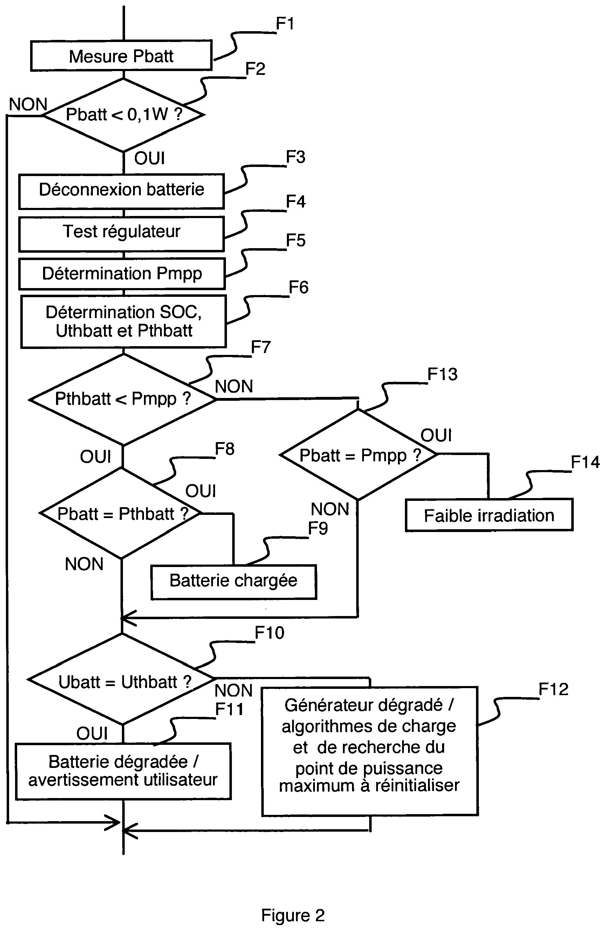

Dans le mode de réalisation particulier illustré par l'organigramme de la figure 2 et correspondant à un régulateur 3 de puissance comportant un convertisseur de puissance, l'unité de contrôle 6 détermine (étape F1) la puissance réelle de charge Pbatt de la batterie 1 à partir des mesures (I/V) de la tension et du courant aux bornes de la batterie 1, fournies par le circuit de mesure 5. Elle compare (F2) la puissance réelle de charge Pbatt de la batterie 1 à un seuil prédéfini,qui est fonction de l'élément de stockage et qui correspond à la puissance de fin de charge, par exemple 0,1 watt.

Si la puissance réelle de charge Pbatt est inférieure au seuil prédéfini (sortie OUI de F2), l'unité de contrôle 6 provoque (F3) la déconnexion de la batterie 1 après avoir mis en mémoire les dernières valeurs de tension et du courant mesurées par les circuits de mesures 4 et 5.

L'unité de contrôle 6 déclenche, ensuite, un protocole de test afin de vérifier que tous les éléments, intervenant dans le processus de charge de la batterie 1, sont fonctionnels. Le protocole de test utilise notamment les valeurs de courant et de tension mesurées juste avant la déconnexion de la batterie 1

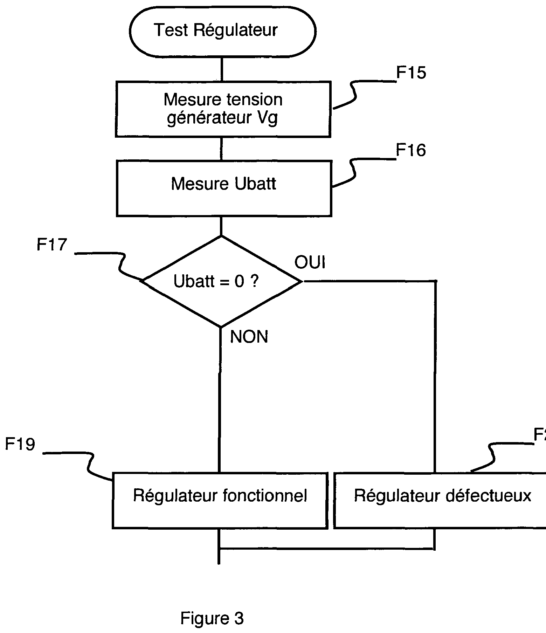

Le protocole de test peut commencer par (F4) un test, facultatif, du régulateur de puissance 3. Un mode particulier de réalisation de ce test sera décrit plus en détail ultérieurement, en référence à la figure 3. Le test a ensuite pour but de détecter un mauvais fonctionnement du générateur et/ou de la batterie 1. Dans une étape F5, l'unité de contrôle 6 calcule la puissance maximale délivrable par le panneau photovoltaïque 2 Pmpp, sur la base de mesures de la tension et du courant aux bornes du panneau photovoltaïque lorsque ce dernier est réglé à son point de puissance maximale, avec l'ensoleillement réel au moment des mesures.

La mesure de ces deux grandeurs (tension et courant) nécessite d'être en mesure de dissiper ou d'utiliser cette puissance dans le système. Or, l'électronique de puissance, n'est pas prévue pour ce type de fonctionnement et n'est donc pas capable de dissiper la totalité de la puissance fournie par le panneau photovoltaïque 2.

Une première possibilité consiste à mesurer successivement la tension à vide Voc et le courant de court-circuit du panneau afin d'en déduire la tension au point de puissance maximale Vmpp et le courant Impp associé. Il faut pour cela commuter rapidement d'un état à l'autre.

Une autre possibilité consiste à faire des variations d'impédance et des mesures très brèves, afin de pouvoir interpoler le point de puissance maximale. La puissance est élevée, mais le temps et donc l'énergie sont faibles. On peut, par exemple, réaliser un certain nombre de mesures pendant la commutation entre le circuit ouvert et le court-circuit.

L'unité de contrôle 6 peut alors avantageusement comparer les valeurs de tension en circuit ouvert Voc et au point de puissance maximale Vmpp à des valeurs nominales, connues. Cette comparaison peut, de plus, permettre de s'assurer que toutes les cellules du panneau photovoltaïque fonctionnent. Si c'est le cas, l'unité de contrôle 6, calcule la puissance Pmpp.

Ensuite, l'unité de contrôle 6 détermine l'état de charge (SOC) de la batterie 1, par exemple, en mesurant la tension à vide et la température T de la batterie 1 (fournies par les circuits de mesure 5 et 7) et au moyen d'abaques. Pour permettre une mesure précise de l'état de charge (SOC), cette étape F6 est préférentiellement réalisée, après une durée d'attente prédéfinie fonction du type, de la température et de l'état de charge de la batterie, typiquement de l'ordre de 10 minutes pour une batterie au Lithium, après déconnexion de la batterie. Cette durée d'attente permet à la batterie de stabiliser sa tension à vide. Cette estimation de l'état de charge (SOC) est avantageusement utilisée par l'unité de contrôle 6 pour définir la puissance de charge souhaitable pour divers profils de charges de la batterie 1. L'unité de contrôle 6 détermine, en particulier, pour l'état de charge déterminé (SOC), la puissance de charge théorique Pthbatt(SOC) ainsi que la tension théorique Uthbatt(T,SOC), qui dépend également de la température de la batterie 1, permettant, en théorie, une charge optimale de la batterie. Les valeurs Pthbatt et Uthbatt utilisées par la suite sont donc fonctions de l'état de charge (SOC) réel de la batterie 1 au moment de leur détermination (étape F6).

Les données relatives à des profils de charge de la batterie 1 comportent, préférentiellement, non seulement le type de batterie utilisé et le courant maximum de charge autorisé, mais aussi la puissance de charge et le type de charge en fonction de l'état de charge de la batterie.

L'unité de contrôle 6 utilise alors différentes grandeurs mesurées et déterminées, pour déterminer l'origine de la faible puissance de charge détectée auparavant (sortie OUI de F2).

Sur la figure 2, la puissance théorique de charge Pthbatt, est (F7) d'abord comparée à la puissance maximale Pmpp.

Si (sortie OUI de F7) la puissance maximale Pmpp du panneau photovoltaïque 2 est supérieure à la puissance théorique de charge de la batterie 1 (Pmpp > Pthbatt), alors le panneau photovoltaïque 2 ne limite pas, a priori, la charge de la batterie 1. La puissance réelle de charge Pbatt est alors comparée (F8) à la puissance théorique de charge Pthbatt de la batterie 1.

Si (sortie OUI de F8), la puissance réelle de charge est égale à la puissance théorique de charge (Pbatt = Pthbatt) de la batterie 1, alors, la batterie 1 est considérée comme chargée (F9), ce qui explique la faible puissance de charge nécessaire à la batterie 1. Dans cette configuration, le système autonome peut avantageusement prévenir l'utilisateur.

Dans un exemple correspondant, lorsque la puissance réelle de charge Pbatt atteint la valeur seuil 0,1 W, l'unité de contrôle 6 mesure une puissance maximale Pmpp délivrable par le panneau photovoltaïque 2 de 10W et un état de charge de la batterie 1 de 95%. Au moyen des données relatives à des profils de charge de la batterie 1, l'unité de contrôle 6 détermine une puissance théorique de charge Pthbatt de 0,1 W. La puissance maximale Pmpp du panneau photovoltaïque 2 est alors supérieure à la puissance théorique de charge de la batterie 1 (Pmpp (10W) > Pthbatt (0,1 W)) et la puissance réelle de charge Pbatt est égale à la puissance théorique de charge (0,1 W) de la batterie 1. La batterie 1 est donc chargée.

Par contre, si (sortie NON de F8) la puissance réelle de charge Pbatt est différente de la puissance théorique de charge Pthbatt, on suppose que la puissance de charge est inférieure à la puissance théorique de charge (Pbatt < Pthbatt) et que la batterie ne se charge pas normalement. En effet, la puissance de charge supérieure à la puissance théorique de charge (Pbatt > Pthbatt), correspond au cas où la batterie 1 est chargée et le régulateur 3 lui délivre plus de puissance que nécessaire. Les puissances en oeuvres étant faibles (Pbatt<0,1Watt), ce cas est assimilé aux erreurs de mesures près au cas précédent Pbatt = Pthbatt. L'unité de contrôle 6 compare alors (F10) les tensions de charge réelle Ubatt et théorique Uthbatt pour détecter l'élément défectueux.

Si (sortie OUI de F10) la tension de charge réelle est égale à la tension théorique fonction de l'état de charge de la batterie 1 et de la température (Ubatt = Uthbatt(T, SOC)), alors, la batterie semble dégradée et l'utilisateur est averti (F11). En effet, on suppose que la principale conséquence de la dégradation de la batterie 1 est une augmentation de son impédance interne et donc un décalage des points de fonctionnement courant et tension de la batterie 1. Dans le cas contraire (sortie NON de F10), on suppose que la tension de charge réelle est inférieure à la tension théorique de charge (Ubatt < Uthbatt(T, SOC)), et c'est le panneau photovoltaïque 2 qui semble dégradé et l'algorithme de recherche du point de puissance maximale du panneau photovoltaïque 2 ainsi que l'algorithme de charge de la batterie 1 sont réinitialisés (F12). En effet, on considère que la principale conséquence de la dégradation du panneau photovoltaïque 2 est la dégradation de sa courbe tension/courant et l'apparition de minima et de maxima locaux qui empêche l'algorithme de recherche du point de puissance maximale de trouver le vrai point de fonctionnement du panneau photovoltaïque 2. Ainsi, le panneau photovoltaïque 2 fonctionne à un point de puissance inférieur à son point maximal. Le cas Ubatt > Uthbatt est considéré comme impossible ou improbable au niveau de l'étape F10.

Dans un exemple correspondant, lorsque la puissance réelle de charge atteint la valeur seuil 0,1 W, l'unité de contrôle 6 mesure une puissance maximale délivrable par le panneau photovoltaïque 2 de 10W et un état de charge de la batterie 1 de 70%. Au moyen des données relatives à des profils de charge de la batterie 1, l'unité de contrôle 6 détermine une puissance théorique de charge Pthbatt de 5W. D'autre part, l'unité de contrôle 6 détermine que la tension de charge Ubatt est inférieure à la tension théorique de charge Uthbatt. La puissance maximale du panneau photovoltaïque 2 est donc supérieure à la puissance théorique de charge de la batterie 1 (Pmpp (10W) > Pthbatt (0,1 W)), la puissance réelle de charge est inférieure à la puissance théorique de charge (Pbatt(0,1 W) < Pthbatt(5W)). Le panneau 2 est donc suspecté être défectueux et l'algorithme de charge ainsi que l'algorithme de recherche du point de puissance maximale (F12) sont réinitialisés.

Dans un autre exemple correspondant, lorsque la puissance réelle de charge atteint la valeur seuil 0,1 W, l'unité de contrôle 6 mesure une puissance maximale délivrable par le panneau photovoltaïque 2 de 1W et un état de charge de la batterie 1 de 70%. La puissance théorique de charge Pthbatt est de 5W. La puissance maximale du panneau photovoltaïque 2 est donc inférieure à la puissance théorique de charge de la batterie 1 (Pmpp (1 W) < Pthbatt (5W)) et la puissance réelle de charge est inférieure à la puissance maximale du panneau photovoltaïque 2 (Pbatt(0,1 W) < Pmpp(1 W)). De plus, la tension de charge Ubatt est égale à la valeur théorique Uthbatt. La batterie 1 est donc suspectée être dégradée et l'utilisateur est averti (F11).

Si (sortie NON de F7) la puissance maximale du panneau est inférieure à la puissance théorique de charge de la batterie (Pmpp < Pthbatt), alors le panneau photovoltaïque 2 limite, a priori, la charge de la batterie 1. La puissance maximale Pmpp du panneau photovoltaïque 2 est alors comparée (F13) à la puissance réelle de charge Pbatt de la batterie 1.

Si (sortie OUI de F13) la puissance réelle de charge de la batterie 1 est égale à la puissance maximale du panneau photovoltaïque 2 (Pbatt = Pmpp), cela signifie que l'irradiation est faible (F14) et que la batterie 1 utilise toute la puissance disponible. Le fonctionnement est donc normal.

Dans un exemple correspondant, lorsque la puissance réelle de charge atteint la valeur seuil 0,1 W, l'unité de contrôle 6 mesure une puissance maximale délivrable par le panneau photovoltaïque 2 de 0,1 W et un état de charge de la batterie 1 de 70%. La puissance théorique de charge Pthbatt est de 5W. La puissance maximale du panneau photovoltaïque 2 est donc inférieure à la puissance théorique de charge de la batterie 1 (Pmpp (0,1W) < Pthbatt (5W)) et la puissance réelle de charge est égale à la puissance maximale du panneau photovoltaïque 2 (0,1 W), Cela signifie donc que l'irradiation est faible (F14) et que le système fonctionne correctement.

Si (sortie NON de F13) la puissance réelle de charge de la batterie 1 n'est pas égale à la puissance maximale du panneau photovoltaïque 2, la puissance de charge ne pouvant jamais être supérieure à la puissance délivrée par le générateur, cela signifie que la puissance réelle de charge de la batterie 1 est inférieure à la puissance maximale du panneau photovoltaïque (Pbatt < Pmpp), et que la batterie ne se charge pas normalement. Dans ces conditions, l'unité de contrôle 6 compare, comme précédemment, (F10) les tensions de charge réelle Ubatt et théorique Uthbatt pour discriminer quel est l'élément défectueux.

De façon plus générale, au sein du protocole de test, la puissance réelle de charge Pbatt est comparée à la plus petite des valeurs représentatives de la puissance théorique de charge Pthbatt de l'élément de stockage d'énergie 1 et de la puissance maximale Pmpp délivrable par le générateur 2. En effet, si la puissance théorique de charge Pthbatt est inférieure à la puissance maximale Pmpp délivrable par le générateur 2 (sortie OUI de F7), la puissance réelle de charge Pbatt est alors comparée à la puissance théorique de charge Pthbatt, dans le cas contraire (sortie NON de F7), la puissance réelle de charge Pbatt est comparée à la puissance maximale délivrable par le générateur 2. De plus, la comparaison de la tension de charge Ubatt avec la tension théorique de charge Uthbatt n'a lieu que si la puissance de charge Pbatt est inférieure à la puissance théorique de charge Pthbatt et à la puissance maximale Pmpp délivrable par le générateur 2.

La réinitialisation d'un algorithme (F11 ou F12) ne permet pas de considérer le générateur 2 comme défectueux la première fois. Dans un mode de réalisation préférentiel, le générateur 2 est signalé comme défectueux après un certain nombre de réinitialisations, par exemple après trois réinitialisations.

Comme représenté à la figure 3, le test du régulateur (F4) peut comporter la mesure la tension aux bornes du régulateur de puissance 3. Dans le système autonome représenté à la figure 1, les mesures des tensions peuvent être réalisées par les circuits de mesure 4 et 5. Dans ce cas de figure particulier, la tension d'entrée du régulateur de puissance correspond à la tension aux bornes du générateur Vg et la tension de sortie du régulateur, Ubatt, est la tension aux bornes de l'élément de stockage 1.

Le protocole de test (F4) du régulateur de puissance 3 peut comporter les étapes suivantes. L'unité de contrôle 6 fait réaliser une nouvelle mesure (F15) de la tension fournie par le générateur 2 ou utilise la valeur préalablement mise en mémoire. L'unité de contrôle 6 fait également réaliser une nouvelle mesure (F16) de la tension fournie à la batterie 1 ou utilise la valeur préalablement mise en mémoire. L'unité de contrôle 6 teste (F17) ensuite si la valeur de la tension fournie à la batterie 1 est nulle.

Si (sortie OUI de F17) la tension fournie à la batterie est nulle, le régulateur de puissance 3 est alors déclaré défectueux (F20). Dans le cas contraire (sortie NON de F17), le régulateur de puissance 3 est considéré comme fonctionnel (F19).

Dans une variante de réalisation, le même problème technique peut être résolu dans un système autonome dont le régulateur de puissance ne comporte pas de convertisseur. Le convertisseur de puissance, étant un élément onéreux, il est également possible de réaliser la charge de la batterie selon un autre protocole de charge.

La régulation de la charge de la batterie 1 à partir du générateur 2 est alors réalisée au moyen des éléments de commutations disposés entre le générateur 2 et la batterie 1. Dans ce cas de figure, lors de la charge, la puissance délivrée par le générateur n'est plus adaptée à la charge de la batterie, il n'est plus possible de faire varier le rapport Uentrée/Usortie. Ainsi, les tensions aux bornes du générateur et de la batterie sont identiques. Dans cette configuration, le générateur et l'élément de stockage sont connectés directement par l'intermédiaire des éléments de commutation.

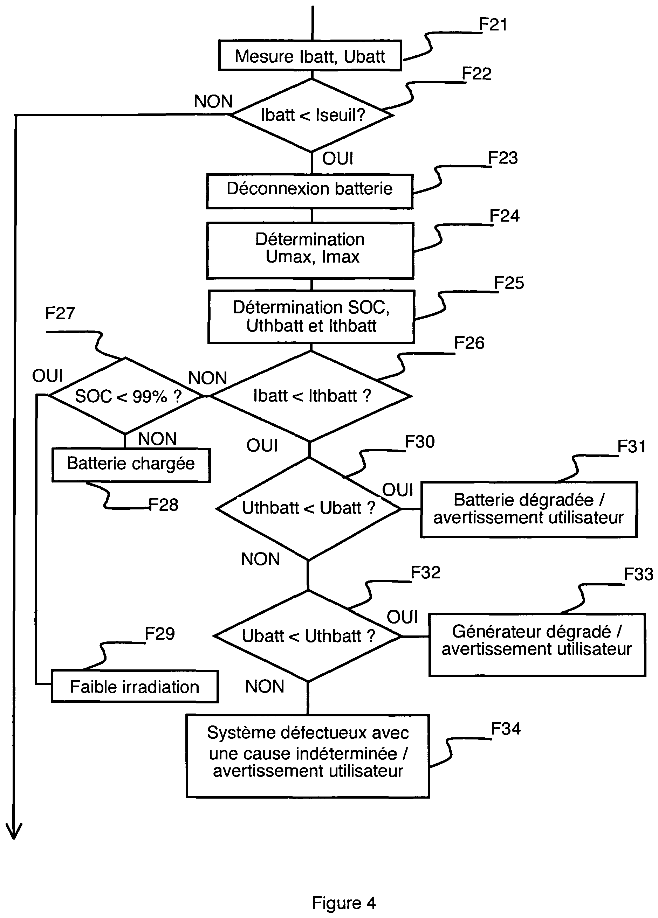

Dans le mode de réalisation particulier illustré par l'organigramme de la figure 4 et correspondant à un régulateur 3 de puissance ne comportant pas de convertisseur de puissance, l'unité de contrôle 6 détermine (étape F21) le courant réel de charge Ibatt de la batterie 1 au moyen du circuit de mesure 5. Avantageusement, la tension réelle de charge est également mesurée au moyen du circuit de mesure 4. L'unité de contrôle 6 compare (F22) le courant réel de charge Ibatt de la batterie 1 à un premier seuil de courant prédéfini Iseuil, préférentiellement égal au courant de fin de charge qui dépend directement de la batterie (type, dimension,...) et qui est typiquement égal à 5% du courant nominal de charge.

Si le courant réel de charge Ibatt est inférieur au seuil prédéfini (sortie OUI de F22), l'unité de contrôle 6 provoque (F23) la déconnexion de la batterie 1 après avoir mis en mémoire les dernières valeurs de tension et du courant mesurées (Ubatt et Ibatt) par les circuits de mesures 4 et 5.

Dans une étape F24, l'unité de contrôle 6 calcule la tension Umax et le courant Imax maximal délivrables par le panneau photovoltaïque 2, sur la base de mesures de la tension et du courant aux bornes du panneau photovoltaïque. Les valeurs maximales de tension et de courant délivrables par le générateur sont indépendantes l'une de l'autre et correspondent à deux conditions distinctes de fonctionnement du générateur, la tension en circuit ouvert et le courant de court-circuit. Au moyen de ces deux informations, l'unité de contrôle détermine la courbe de fonctionnement normal du générateur. Cette courbe est calculée au moyen de données spécifiques représentatives du générateur et qui sont intégrées dans la mémoire de l'unité de contrôle.

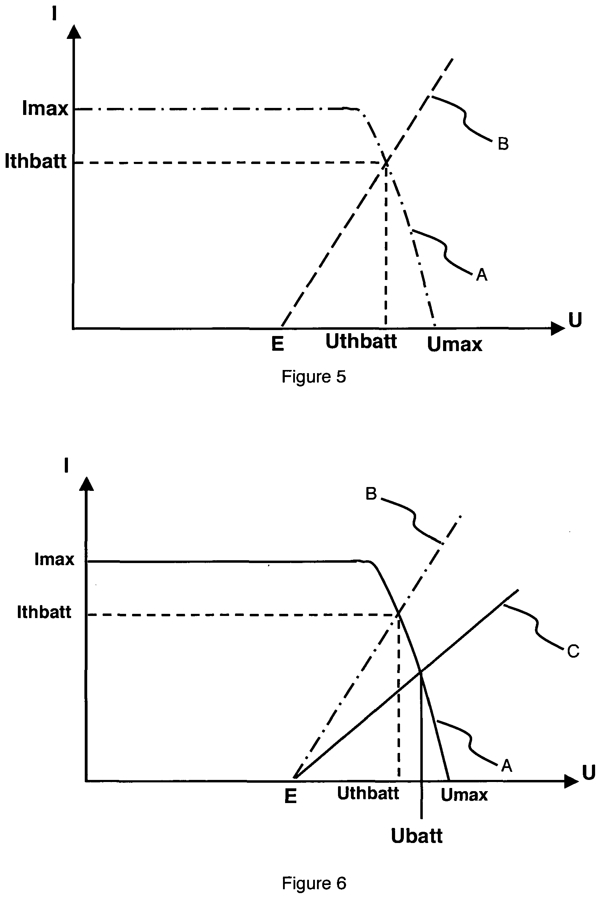

Comme illustré à la figure 5, la courbe A de fonctionnement du générateur calculée par l'unité de contrôle 6 représente la relation qui lie le courant délivré et la tension aux bornes du générateur dans un fonctionnement normal. On observe que dans un premier domaine qui correspond aux valeurs de tension les plus faibles, le courant délivrable est sensiblement maximal et constant, c'est le courant maximal Imax. Ensuite, au fur et à mesure que la tension augmente, le courant diminue de façon sensiblement linéaire jusqu'à être nul. Lorsque le courant délivré par le générateur est nul, la tension aux bornes de ce même générateur est maximale et correspond à la tension maximale Umax. La courbe A de fonctionnement du générateur tient donc compte des données climatiques actuelles, par exemple l'ensoleillement (irradiation et température).

Ensuite, l'unité de contrôle 6 détermine l'état de charge (SOC) de la batterie 1 (F25). Le protocole de détermination de l'état de charge est avantageusement identique à celui expliqué précédemment. Cette estimation de l'état de charge (SOC) est avantageusement utilisée par l'unité de contrôle 6 pour définir les paramètres de charge souhaitables pour divers profils de charges de la batterie 1.

L'unité de contrôle 6 possède également en mémoire, les caractéristiques générales de l'élément de stockage et est ainsi en mesure de connaître, dans un fonctionnement normal, la relation qui existe entre le courant de charge et la tension à ses bornes. Cette relation est typiquement représentée par la courbe B (figure 5) et est de la forme U = E+RI dans laquelle :
U est la tension aux bornes de l'élément de stockage,
E est la force électromotrice de l'élément de stockage,
R est la résistance interne de l'élément de stockage,
I est le courant de charge.

De manière conventionnelle, la force électromotrice E de l'élément de stockage évolue en fonction de l'état de charge (SOC) de la batterie. De plus, selon le type de batterie utilisée, il est possible d'observer de faibles variations de la résistance interne R de l'élément de stockage.

L'unité de contrôle 6 calcule alors la valeur de la tension théorique de charge et le courant théorique de charges (Uthbatt/Ithbatt) qui correspondent à l'adéquation entre les caractéristiques électriques délivrables par le générateur et les caractéristiques électriques imposées par la charge de l'élément de stockage 1, c'est-à-dire l'intersection des courbes A et B de la figure 5. De cette manière, les tension et courant de charge déterminés par l'unité de contrôle 6 correspondent aux tension et courant théoriques de charge Uthbatt et Ithbatt.

Ainsi, pour l'état de charge déterminé (SOC), l'unité de contrôle 6 détermine, le courant théorique de charge Ithbatt et la tension théorique Uthbatt(T,SOC), qui dépend également de la température de la batterie 1. Ce couple courant/tension théoriques de charge(Uthbatt/Ithbatt) permet, en théorie, une charge optimale de la batterie.

Comme précisé précédemment, le générateur et l'élément de stockage étant en connexion directe, la tension aux bornes de l'élément de stockage et du générateur est identique et le courant qui quitte le générateur correspond à celui qui charge l'élément de stockage. Il en résulte que le point de fonctionnement doit appartenir aux courbes A et B. Le courant théorique de charge est donc toujours inférieur à Imax et évolue au fur et à mesure de la charge de la batterie depuis Imax jusqu'au courant de fin de charge par exemple Iseuil. Le déplacement du courant théorique de charge sur la caractéristique (U/I) du générateur est fonction des caractéristiques du générateur et de la batterie.

Avantageusement, les caractéristiques de l'élément de stockage et du générateur sont choisies de manières à ce que le courant théorique de charge Ithbatt ne soit pas inférieur à une valeur limite, par exemple 80% du courant maximal délivrable (0,8.Imax), ce qui correspond sensiblement au point de puissance maximale délivrable Pmpp par le générateur 2. Cette condition lie la taille du générateur à la taille de la batterie. Si le générateur est surdimensionné par rapport à l'exemple précédent (0,8.Imax), le courant théorique de charge Ithbatt peut ne pas être inférieur à 90% du courant maximal délivrable voire être sensiblement égale au courant maximal délivrable Imax. A titre d'exemple, ce type de montage peut être mis en oeuvre pour la charge d'une batterie au plomb qui supporte un courant élevé en fin de charge. Dans le cas contraire, si l'on veut éviter de fournir un courant élevé en fin de charge, le générateur est sous-dimensionné.

Les valeurs Uthbatt et Ithbatt utilisées par la suite sont fonctions de l'état de charge (SOC) réel de la batterie 1 au moment de sa détermination (étape F6).

L'unité de contrôle 6 utilise alors différentes grandeurs mesurées et déterminées, pour déterminer l'origine du faible courant de charge détecté auparavant (sortie OUI de F22).

Sur la figure 4, le courant réel de charge Ibatt est comparé (F26) au courant théorique de charge Ithbatt pour vérifier si le courant réel de charge Ibatt est inférieur au courant théorique de charge (Ibatt < Ithbatt).

Si (sortie NON de F26) le courant réel de charge Ibatt est supérieur ou égale au courant théorique de charge Ithbatt, alors le système autonome fonctionne normalement.

Avantageusement, l'état de charge de la batterie est alors comparé à un état de fin de charge prédéterminé (F27), par exemple 99% (SOC<99%). Si (sortie NON de F27) l'état de charge est supérieur ou égale à l'état de fin de charge prédéterminé, la batterie est considérée comme chargée (F28). Dans le cas contraire (sortie OUI de F27), le panneau photovoltaïque 2 limite, a priori, la charge de la batterie 1 cela signifie que l'irradiation est faible (F29) et que la batterie 1 utilise toute le courant disponible.

Si (sortie OUI de F26), le courant réel de charge est inférieur au courant théorique de charge (Ibatt < Ithbatt), on suppose alors que le système autonome a un fonctionnement anormal et la recherche de l'élément défectueux est réalisée.

La tension théorique de charge Uthbatt, est (F30) ensuite comparée à la tension de charge Ubatt pour vérifier si la tension réelle de charge Ubatt est supérieure à la tension théorique de charge de la batterie 1 (Ubatt > Uthbatt).

Si (sortie OUI de F30) la tension réelle de charge Ubatt est supérieure à la tension théorique de charge de la batterie 1 (Ubatt > Uthbatt), alors la batterie semble dégradée et l'utilisateur est averti (F31). En effet, on suppose que la principale conséquence de la dégradation de la batterie 1 est une augmentation de son impédance interne et donc un décalage des points de fonctionnement courant et tension de la batterie 1, comme illustré par la courbe C à la figure 6.

Dans le cas contraire (sortie NON de F30), on compare de nouveau la tension théorique de charge Uthbatt et la tension de charge Ubatt (F32) pour vérifier si la tension réelle de charge Ubatt est inférieure à la tension théorique de charge de la batterie 1 (Ubatt < Uthbatt).

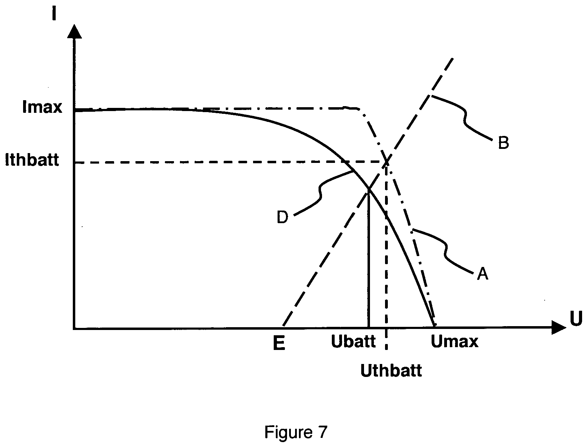

Si (sortie OUI de F32) la tension réelle de charge Ubatt est inférieure à la tension théorique de charge de la batterie 1 (Ubatt < Uthbatt), alors c'est le panneau photovoltaïque 2 qui semble dégradé (F33). En effet, on considère que la principale conséquence de la dégradation du panneau photovoltaïque 2 est la dégradation de sa courbe tension/courant, c'est-à-dire que sa courbe tension/courant est située sous sa courbe tension/courant nominale, comme illustré par la courbe D à la figure 7. Il en résulte donc un décalage des points de fonctionnement courant et tension de la batterie 1 par rapport aux points de fonctionnement théorique. Ainsi, le panneau photovoltaïque 2 est donc suspecté être défectueux et l'utilisateur est averti (F33).

Dans le cas contraire (sortie NON de F32), la tension théorique de charge Uthbatt est égale à la tension de charge Ubatt, le fonctionnement du système autonome est anormal, mais aucune cause ne peut être déterminée et l'utilisateur est averti (F34). Ce cas de figure peut correspondre à une dégradation simultanée du générateur et de la batterie.

## Revendications

1. Procédé de diagnostic d'éléments défectueux dans un système autonome, alimenté par une source d'alimentation intermittente et comportant en série un générateur (2), un régulateur de puissance (3) et un élément de stockage d'énergie (1), régulateur comportant un convertisseur disposé entre le générateur (2) et l'élément de stockage d'énergie (1), le procédé comportant
- la mesure du courant et de la tension (Ubatt) réels de charge, la détermination en fonction desdites mesures de la puissance réelle de charge (Pbatt) de l'élément de stockage d'énergie (1), la comparaison de ladite puissance réelle de charge à un seuil de puissance prédéfini,
- la déconnexion de l'élément de stockage d'énergie (1) si la puissance de charge est inférieure au seuil de puissance,
- l'élément de stockage d'énergie (1) étant déconnecté, la mesure de la puissance maximale (Pmpp) délivrable par le générateur (2) à l'instant de la mesure, la détermination de l'état de charge (SOC) de l'élément de stockage d'énergie (1) déconnecté, ainsi que la détermination, à partir de l'état de charge (SOC), de la tension (Uthbatt) et de la puissance (Pthbatt) théoriques de charge pour une charge optimale de la batterie, la tension théorique (Uthbatt) dépendante également de la température de l'élément de stockage d'énergie,
- la différenciation entre un comportement normal, un mauvais fonctionnement du générateur (2) et un mauvais fonctionnement de l'élément de stockage d'énergie (1) en fonction de la comparaison entre la puissance réelle de charge (Pbatt) de l'élément de stockage (1) et la plus petite des valeurs représentatives de la puissance théorique (Pthbatt) de charge de l'élément de stockage d'énergie (1) et de la puissance maximale (Pmpp) délivrable par le générateur (2) et de la comparaison entre la tension réelle (Ubatt) de charge et la tension théorique (Uthbatt) de charge de l'élément de stockage d'énergie (1).

2. Procédé selon la revendication 1 **caractérisé en ce qu'**il comporte la mesure des tensions d'entrée et de sortie du régulateur de puissance (3) et la détection d'un défaut dans le dispositif du régulateur de puissance (3) en fonction desdites mesures.

3. Procédé selon la revendication 2, **caractérisé en ce que** le régulateur de puissance (3) est considéré comme défectueux si sa tension de sortie (Ubatt) est nulle.

4. Procédé selon l'une quelconque des revendications 1 à 3, **caractérisé en ce que** si la puissance réelle de charge (Pbatt) de l'élément de stockage (1) est inférieure à la puissance théorique de charge (Pthbatt) et à la puissance maximale (Pmpp) délivrable par le générateur (2) et si la tension théorique de charge (Uthbatt) est égale à la tension réelle de charge (Ubatt), l'élément de stockage d'énergie (1) est considéré comme dégradé (F11).

5. Procédé selon la revendication 4, **caractérisé en ce que** si l'élément de stockage d'énergie (1) est considéré comme dégradé, la signalisation de la défectuosité est réalisée.

6. Procédé selon l'une quelconque des revendications 1 à 3, **caractérisé en ce que** si la puissance réelle de charge (Pbatt) de l'élément de stockage d'énergie (1) est inférieure à la puissance maximale (Pmpp) délivrable par le générateur (2) et à la puissance théorique de charge (Pthbatt) et si la tension théorique de charge (Uthbatt) est supérieure à la tension réelle de charge (Ubatt), le générateur (2) est considéré comme dégradé (F12).

7. Procédé selon la revendication 6, **caractérisé en ce que** si le générateur (2) est considéré comme dégradé, un algorithme de charge est réinitialisé.

8. Procédé selon l'une des revendications 6 et 7, **caractérisé en ce que** si le générateur (2) est considéré comme dégradé, un algorithme de recherche du point de puissance maximale du régulateur (3) est réinitialisé.

9. Procédé selon l'une des revendications 7 et 8, **caractérisé en ce qu'**il comporte la signalisation de la défectuosité du générateur (2) après un nombre prédéfini de réinitialisations successives d'au moins un algorithme.

10. Procédé de diagnostic d'éléments défectueux dans un système autonome, alimenté par une source d'alimentation intermittente et comportant un générateur (2) connecté à un élément de stockage d'énergie (1), la source d'alimentation et l'élément de stockage d'énergie (1) étant connectés directement par des moyens de commutation, le procédé comportant
- la mesure d'un courant réel de charge (Ibatt) et d'une tension réelle de charge (Ubatt), la comparaison du courant réel de charge (Ibatt) à un premier seuil de courant prédéfini (Iseuil),
- la déconnexion de l'élément de stockage d'énergie (1) si ledit courant réel de charge (Ibatt) est inférieur au seuil de courant (Iseuil),
- l'élément de stockage d'énergie (1) étant déconnecté, la mesure du courant maximal (Imax) et de la tension maximale (Umax) délivrables par le générateur (2) à l'instant de la mesure, la détermination de l'état de charge (SOC) de l'élément de stockage d'énergie (1) déconnecté, la détermination à partir de l'état de charge (SOC) d'un courant théorique de charge (Ithbatt) et d'une tension théorique de charge (Uthbatt) pour une charge optimale de la batterie sur la caractéristique de fonctionnement du générateur, la tension théorique (Uthbatt) dépendante également de la température de l'élément de stockage d'énergie,
- la différenciation entre un comportement normal, un mauvais fonctionnement du système autonome en fonction de la comparaison du courant réel de charge (Ibatt) avec le courant théorique de charge (Ithbatt).

11. Procédé selon la revendication 10, **caractérisé en ce que** le courant réel de charge (Ibatt) étant inférieur au courant théorique de charge (Ithbatt), si la tension réelle de charge (Ubatt) de l'élément de stockage (1) est inférieure à la tension théorique de charge (Uthbatt), le générateur (2) est considéré comme dégradé (F33).

12. Procédé selon la revendication 11, **caractérisé en ce que** si le générateur (2) est considéré comme dégradé, la signalisation de la défectuosité est réalisée.

13. Procédé selon la revendication 10, **caractérisé en ce que** le courant réel de charge (Ibatt) étant inférieur au courant théorique de charge (Ithbatt), si la tension réelle de charge (Ubatt) de l'élément de stockage (1) est supérieure à la tension théorique de charge (Uthbatt), l'élément de stockage d'énergie (1) est considéré comme dégradé (F31).

14. Procédé selon la revendication 13, **caractérisé en ce que** si l'élément de stockage d'énergie (1) est considéré comme dégradé, la signalisation de la défectuosité est réalisée.

15. Procédé selon la revendication 10, **caractérisé en ce que** le courant réel de charge (Ibatt) étant inférieur au courant théorique de charge (Ithbatt), si la tension réelle de charge (Ubatt) de l'élément de stockage (1) est égale à la tension théorique de charge (Uthbatt), le système autonome est considéré comme dégradé selon une cause indéterminée (F34).

16. Procédé selon la revendication 15, **caractérisé en ce que** si le système autonome est considéré comme dégradé, la signalisation de la défectuosité est réalisée.

17. Procédé selon l'une quelconque des revendications 1 à 16, **caractérisé en ce que** le générateur (2) est un panneau photovoltaïque.

18. Procédé selon l'une quelconque des revendications 1 à 16, **caractérisé en ce que** le générateur (2) est de type éolien.

## Patentansprüche

1. Verfahren zum Diagnostizieren defekter Elemente in einem autonomen System, das durch eine intermittierende Versorgungsquelle versorgt wird und in Reihe einen Generator (2), einen Leistungsregler (3) und ein Energiespeicherungselement (1) umfasst, wobei der Regler einen zwischen dem Generator (2) und dem Energiespeicherungselement (1) angeordneten Wandler umfasst, wobei das Verfahren umfasst
- das Messen des tatsächlichen Ladestroms und der tatsächlichen Ladespannung (Ubatt), die Bestimmung der tatsächlichen Ladeleistung (Pbatt) des Energiespeicherungselements (1) in Abhängigkeit von den Messungen, das Vergleichen der tatsächlichen Ladeleistung mit einer vordefinierten Leistungsschwelle,
- das Trennen des Energiespeicherungselements (1), wenn die Ladeleistung unterhalb der Leistungsschwelle liegt,
- wenn das Energiespeicherungselement (1) getrennt ist, das Messen der maximalen Leistung (Pmpp), die durch den Generator (2) zum Zeitpunkt der Messung lieferbar ist, die Bestimmung des Ladezustands (SOC) des getrennten Energiespeicherungselements (1) sowie die Bestimmung der theoretischen Ladespannung (Uthbatt) und der theoretischen Ladeleistung (Pthbatt) anhand des Ladezustands (SOC) für ein optimales Laden der Batterie, wobei die theoretische Spannung (Uthbatt) auch von der Temperatur des Energiespeicherungselements abhängt,
- die Differenzierung zwischen einem normalen Verhalten, einer Fehlfunktion des Generators (2) und einer Fehlfunktion des Energiespeicherungselements (1) in Abhängigkeit von dem Vergleich zwischen der tatsächlichen Ladeleistung (Pbatt) des Speicherungselements (1) und dem kleinsten der Werte, die für die theoretische Ladeleistung (Pthbatt) des Energiespeicherungselements (1) und für die durch den Generator (2) lieferbare maximale Leistung (Pmpp) repräsentativ sind, sowie von dem Vergleich zwischen der tatsächlichen Ladespannung (Ubatt) und der theoretischen Ladespannung (Uthbatt) des Energiespeicherungselements (1).

2. Verfahren nach Anspruch 1, **dadurch gekennzeichnet, dass** es das Messen der Eingangs- und Ausgangsspannungen des Leistungsreglers (3) sowie die Erfassung eines Fehlers in der Vorrichtung des Leistungsreglers (3) in Abhängigkeit von den Messungen umfasst.

3. Verfahren nach Anspruch 2, **dadurch gekennzeichnet, dass** der Leistungsregler (3) als defekt betrachtet wird, wenn seine Ausgangsspannung (Ubatt) null ist.

4. Verfahren nach einem der Ansprüche 1 bis 3, **dadurch gekennzeichnet, dass** wenn die tatsächliche Ladeleistung (Pbatt) des Speicherungselements (1) kleiner als die theoretische Ladeleistung (Pthbatt) und als die durch den Generator (2) lieferbare maximale Leistung (Pmpp) ist und wenn die theoretische Ladespannung (Uthbatt) gleich der tatsächlichen Ladespannung (Ubatt) ist, das Energiespeicherungselement (1) als beschädigt betrachtet wird (F11).

5. Verfahren nach Anspruch 4, **dadurch gekennzeichnet, dass** wenn das Energiespeicherungselement (1) als beschädigt betrachtet wird, die Signalisierung des Defektes erfolgt.

6. Verfahren nach einem der Ansprüche 1 bis 3, **dadurch gekennzeichnet, dass** wenn die tatsächliche Ladeleistung (Pbatt) des Energiespeicherungselements (1) kleiner als die durch den Generator (2) lieferbare maximale Leistung (Pmpp) und als die theoretische Ladeleistung (Pthbatt) ist und wenn die theoretische Ladespannung (Uthbatt) größer als die tatsächliche Ladespannung (Ubatt) ist, der Generator (2) als beschädigt betrachtet wird (F12).

7. Verfahren nach Anspruch 6, **dadurch gekennzeichnet, dass** wenn der Generator (2) als beschädigt betrachtet wird, ein Ladealgorithmus reinitialisiert wird.

8. Verfahren nach einem der Ansprüche 6 und 7, **dadurch gekennzeichnet, dass** wenn der Generator (2) als beschädigt betrachtet wird, ein Algorithmus zur Suche des maximalen Leistungspunktes des Reglers (3) reinitialisiert wird.

9. Verfahren nach einem der Ansprüche 7 und 8, **dadurch gekennzeichnet, dass** es die Signalisierung des Defektes des Generators (2) nach einer vordefinierten Anzahl von aufeinanderfolgenden Reinitialisierungen wenigstens eines Algorithmus umfasst.

10. Verfahren zum Diagnostizieren defekter Elemente in einem autonomen System, das durch eine intermittierende Versorgungsquelle versorgt wird und einen Generator (2), welcher mit einem Energiespeicherungselement (1) verbunden ist, umfasst, wobei die Versorgungsquelle und das Energiespeicherungselement (1) direkt über Schaltmittel verbunden sind, wobei das Verfahren umfasst
- das Messen eines tatsächlichen Ladestroms (Ibatt) und einer tatsächlichen Ladespannung (Ubatt), das Vergleichen des tatsächlichen Ladestroms (Ibatt) mit einer ersten vordefinierten Stromschwelle (Iseuil),
- das Trennen des Energiespeicherungselements (1), wenn der tatsächliche Ladestrom (Ibatt) unterhalb der Stromschwelle (Iseuil) liegt,
- wenn das Energiespeicherungselement (1) getrennt ist, das Messen des maximalen Stroms (Imax) und der maximalen Spannung (Umax) die durch den Generator (2) zum Zeitpunkt der Messung lieferbar sind, die Bestimmung des Ladezustands (SOC) des getrennten Energiespeicherungselements (1), die Bestimmung eines theoretischen Ladestroms (Ithbatt) und einer theoretischen Ladespannung (Uthbatt) anhand des Ladezustands (SOC) für ein optimales Laden der Batterie auf der Betriebskennlinie des Generators, wobei die theoretische Spannung (Uthbatt) auch von der Temperatur des Energiespeicherungselements abhängt,
- die Differenzierung zwischen einem normalen Verhalten, einer Fehlfunktion des autonomen Systems in Abhängigkeit von dem Vergleich des tatsächlichen Ladestroms (Ibatt) mit dem theoretischen Ladestrom (Ithbatt).

11. Verfahren nach Anspruch 10, **dadurch gekennzeichnet, dass** wenn der tatsächliche Ladestrom (Ibatt) kleiner als der theoretische Ladestrom (Ithbatt) ist, falls die tatsächliche Ladespannung (Ubatt) des Speicherungselements (1) kleiner als die theoretische Ladespannung (Uthbatt) ist, der Generator (2) als beschädigt betrachtet wird (F33).

12. Verfahren nach Anspruch 11, **dadurch gekennzeichnet, dass** wenn der Generator (2) als beschädigt betrachtet wird, die Signalisierung des Defektes erfolgt.

13. Verfahren nach Anspruch 10, **dadurch gekennzeichnet, dass** wenn der tatsächliche Ladestrom (Ibatt) kleiner als der theoretische Ladestrom (Ithbatt) ist, falls die tatsächliche Ladespannung (Ubatt) des Speicherungselements (1) größer als die theoretische Ladespannung (Uthbatt) ist, das Energiespeicherungselement (1) als beschädigt betrachtet wird (F31).

14. Verfahren nach Anspruch 13, **dadurch gekennzeichnet, dass** wenn das Energiespeicherungselement (1) als beschädigt betrachtet wird, die Signalisierung des Defektes erfolgt.

15. Verfahren nach Anspruch 10, **dadurch gekennzeichnet, dass** wenn der tatsächliche Ladestrom (Ibatt) kleiner als der theoretische Ladestrom (Ithbatt) ist, falls die tatsächliche Ladespannung (Ubatt) des Speicherungselements (1) gleich der theoretischen Ladespannung (Uthbatt) ist, das autonome System als nach einem unbestimmten Grund beschädigt betrachtet wird (F34).

16. Verfahren nach Anspruch 15, **dadurch gekennzeichnet, dass** wenn das autonome System als beschädigt betrachtet wird, die Signalisierung des Defektes erfolgt.

17. Verfahren nach einem der Ansprüche 1 bis 16, **dadurch gekennzeichnet, dass** der Generator (2) ein Photovoltaik-Paneel ist.

18. Verfahren nach einem der Ansprüche 1 bis 16, **dadurch gekennzeichnet, dass** der Generator (2) vom Windkrafttyp ist.

## Claims

1. A method for diagnosing defective elements in a standalone system powered by an intermittent power source and comprising in series a generator (2), a power regulator (3) and a power storage element (1), said regulator comprising a converter arranged between the generator (2) and the power storage element (1), the method comprising
- measuring the effective charging current and voltage (Ubatt), determining the effective charging power (Pbatt) of the storage element (1) according to said measurements, and comparing said effective charging power with a predefined power threshold,
- disconnecting the power storage element (1) if the charging power is lower than the power threshold,
- the power storage element (1) being disconnected, measuring the maximum power (Pmpp) able to be delivered by the generator (2) at the time of measuring, determining the state of charge (SOC) of the disconnected power storage element (1), and determining from the state of charge (SOC) a voltage (Uthbatt) and a charging power (Pthbatt) for an optimal charging of the battery, said theoretical voltage (Uthbatt) also depending on the power storage element (1) temperature,
- differentiating between a normal behavior, malfunctioning of the generator (2) and malfunctioning of the power storage element (1) according to the comparison between the effective charging power (Pbatt) of the storage element (1) and the smaller of the values representative of the theoretical charging power (Pthbatt) of the storage element (1) and of the maximum power (Pmpp) able to be delivered by the generator (2), and by comparing the effective charging voltage (Ubatt) and the theoretical charging voltage (Uthbatt) of the power storage element (1).

2. The method according to claim 1, **characterized in that** it comprises measurement of the input and output voltages of the power regulator (3) and detection of a fault in the device of the power regulator (3) according to said measurements.

3. The method according to claim 2, **characterized in that** the power regulator (3) is considered to be defective if its output voltage (Ubatt) is zero.

4. The method according to any one of claims 1 to 3, **characterized in that** if the effective charging power (Pbatt) of the power storage element (1) is lower than the theoretical charging power (Pthbatt) and to the maximum power (Pmpp) able to be delivered by the generator (2) and if the theoretical charging voltage (Uthbatt) is equal to the effective charging voltage (Ubatt), the power storage element (1) is considered to be degraded (F11).

5. The method according to claim 4, **characterized in that** if the power storage element (1) is considered to be degraded, indication of defectiveness is performed.

6. The method according to any one of claims 1 to 3, **characterized in that** if the effective charging power (Pbatt) of the power storage element (1) is lower than the maximum power (Pmpp) able to be delivered by the generator (2) and than the theoretical charging power (Pthbatt) and if the theoretical charging voltage (Uthbatt) is greater than the effective charging voltage (Ubatt), the generator (2) is considered to be degraded (F12).

7. The method according to claim 6, **characterized in that** if the generator (2) is considered to be degraded, a charging algorithm is reinitialized.

8. The method according to one of claims 6 and 7, **characterized in that** if the generator (2) is considered to be degraded, a search algorithm of the maximum power point of the regulator (3) is reinitialized.

9. The method according to one of claims 7 and 8, **characterized in that** it comprises indication of defectiveness of the generator (2) after a predefined number of successive reinitializations of at least one algorithm.

10. A method for diagnosing defective elements in a standalone system powered by an intermittent power source and comprising a generator (2) connected to a power storage element (1), the power source and the power storage element (1) being connected directly by switching means, the method comprising
- measuring a effective charging current (Ibatt) and a effective charging voltage (Ubatt), comparing the effective charging current (Ibatt) with a predefined first current threshold (Ithresh),
- disconnecting the power storage element (1) if said effective charging current (Ibatt) is lower than the current threshold (Ithresh),
- the power storage element (1) being disconnected, measuring the maximum current (Imax) and maximum voltage (Umax) able to be delivered by the generator (2) at the time of measuring, determining the state of charge (SOC) of the disconnected power storage element (1), and determining from the state of charge (SOC) a theoretical charging current (Ithbatt) and a theoretical charging voltage (Uthbatt) for an optimal charging of the battery according to the operating point of the generator, said theoretical voltage (Uthbatt) also depending on the power storage element (1) temperature,
- differentiating between a normal behavior and malfunctioning of the standalone system according to comparison of the effective charging current (Ibatt) with the theoretical charging current (Ithbatt).

11. The method according to claim 10. **characterized in that** the effective charging current (Ibatt) being lower than the theoretical charging current (Ithbatt), if the effective charging voltage (Ubatt) of the power storage element (1) is lower than the theoretical charging voltage (Uthbatt), the generator (2) is considered to be degraded (F33).

12. The method according to claim 11, **characterized in that** if the generator (2) is considered to be degraded, indication of defectiveness is performed.

13. The method according to claim 10. **characterized in that** the effective charging current (Ibatt) being lower than the theoretical charging current (Ithbatt), if the effective charging voltage (Ubatt) of the power storage element (1) is greater than the theoretical charging voltage (Uthbatt), the power storage element (1) is considered to be degraded (F31).

14. The method according to claim 13, **characterized in that** if the power storage element (1) is considered to be degraded, indication of defectiveness is performed.

15. The method according to claim 10, **characterized in that** the effective charging current (Ibatt) being lower than the theoretical charging current (Ithbatt), if the effective charging voltage (Ubatt) of the power storage element (1) is equal to the theoretical charging voltage (Uthbatt), the standalone system is considered to be degraded due to an indeterminate cause (F34).

16. The method according to claim 15, **characterized in that** if the standalone system is considered to be degraded, indication of defectiveness is performed.

17. The method according to any one of claims 1 to 16, **characterized in that** the generator (2) is a photovoltaic panel.

18. The method according to any one of claims 1 to 16, **characterized in that** the generator (2) is a wind power generator.
